(19) Europäisches Patentamt
European Patent Office
Office européen des brevets

(11) Publication number: **0 020 473**
**B1**

(12) # EUROPEAN PATENT SPECIFICATION

(45) Date of publication of patent specification: **22.06.83**

(51) Int. Cl.³: **G 03 C 1/68,** G 03 C 5/24

(21) Application number: **79901300.8**

(22) Date of filing: **11.09.79**

(86) International application number:
**PCT/US79/00713**

(87) International publication number:
**WO 80/00623 03.04.80 Gazette 80/7**

(54) **PHOSPHINE ACTIVATED PHOTOSENSITIVE COMPOSITIONS AND PHOTOPOLYMER PRINTING PLATES MADE THEREFROM.**

(30) Priority: **11.09.78 US 941519**
**27.08.79 US 70190**

(43) Date of publication of application:
**07.01.81 Bulletin 81/1**

(45) Publication of the grant of the patent:
**22.06.83 Bulletin 83/25**

(84) Designated Contracting States:
**AT CH DE FR GB SE**

(56) References cited:
**FR - A - 2 173 881**
**US - A - 3 668 093**
**US - A - 3 767 547**
**US - A - 899 338**
**US - A - 3 933 682**
**US - A - 3 966 573**
**US - A - 4 042 386**
**US - A - 4 069 056**
**US - A - 4 077 860**

**The file contains technical information submitted after the application was filed and not included in this specification**

(73) Proprietor: **NAPP SYSTEMS (USA) INC.**
**360 South Pacific P.O. Box 246**
**San Marcos, CA 92069 (US)**

(72) Inventor: **OKAI, Sakuo**
**2410 LaMacarena Avenue**
**Carlsbad CA 92008 (US)**
Inventor: **KIMOTO, Koichi**
**3222 Waring Road**
**Oceanside CA 92054 (US)**

(74) Representative: **Spencer, Graham Easdale**
**A.A. Thornton & Co Northumberland House**
**303-306, High Holborn**
**London WC1V 7LE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England

**EP 0 020 473 B1**

# Phosphine activated photosensitive compositions and photopolymer printing plates made therefrom

The present invention relates to water-developable photopolymerizable compositions, and photosensitive elements and photopolymer printing plates incorporating such compositions.

Many photopolymerizable compositions and photosensitive elements useful in making printing plates are known in the art. One, if not the most, commercially successful of all such prior art compositions is described in U.S. Patent 3,801,328 (Takimoto). Such compositions, although they have met with enormous commercial success, nevertheless require some form of pre-exposure conditioning before imagewise exposure in order to produce commercially satisfactory relief images on printing plates that employ such compositions.

Two techniques for pre-exposure conditioning have evolved in the art. The first, commonly known as $CO_2$ conditioning, requires the maintenance of the photosensitive element or plate in a $CO_2$ atmosphere until just prior to the imagewise exposure of the element or plate. The second known technique, which has supplanted the $CO_2$ conditioning technique and is commonly known as "bump exposure", requires that the photosensitive element or plate be subjected to a brief (typically 2 to 8 seconds) light exposure immediately prior to the longer duration imagewise exposure, in the presence of a negative.

It has been recognized, of course, that both pre-exposure conditioning techniques require special, costly and time consuming additional handling of the photosensitive element or plate which, from a plate processing standpoint should desirably be eliminated. Moreover, both techniques make the design and operation of automatic plate exposure and processing equipment unduly complicated and expensive. Perhaps even more importantly, both techniques, because of the necessity that imagewise exposure be carried out within a designated time period after pre-exposure conditioning occurs, introduce time controls in plate processing that are often difficult, if not impossible, to maintain in the large quantity, commercial (newspaper) applications for such plates.

We have found that a printing plate which has been "bump" exposed should desirably be imagewise exposed within approximately 30 seconds after completion of bump exposure. Variations in the period between completion of bump exposure and the initiation of imagewise exposure can produce developed plates having very different printing quality characteristics. Thus, two plates utilizing the same photopolymer composition and same negative can have different printing characteristics simply because of differences in the period between bump and imagewise exposure.

Moreover, photosensitive elements and plates, which are subjected to bump exposure, must typically be exposed under high intensity point sources of actinic light, such as carbon arc lamps or high pressure mercury vapour lamps. Such lamps not only have extremely high current demands and short lives, but in normal operation produce unwanted heat, which can cause or contribute to the degradation of the photopolymerizable compositions or cause negatives to stick to the plate photopolymer surface.

As a result of the many inconveniences, the added expenses and variations in product quality inherent in the use of plates requiring some form of pre-conditioning, either through $CO_2$ conditioning or bump exposure, a need has developed for water-developable photopolymerizable compositions (and resultant elements and plates) that entirely eliminate the necessity of pre-exposure conditioning, yet at the same time provide all of the advantageous properties of the commercially desirable compositions of the type described in the above-mentioned U.S. Patent 3,801,328. One such effort to solve the pre-exposure conditioning problem is described in U.S. Patent 4,042,386, which describes a photopolymerisable composition comprising at least one water-soluble ethylenically unsaturated monomer, partially saponified polyvinyl acetate having defined properties, and a photoinitiator. In this photopolymerisable composition, the selection of the specific ingredients in specific amounts with specific properties is intended to eliminate the need for pre-exposure conditioning. This approach, however, suffers from the disadvantage that only carefully selected components, ratios and amounts of the various ingredients can be used, and from the additional disadvantage that only costly high intensity light sources (which have shortened lamp lives and generate excessive amounts of undesired heat) can be used. Moreover, we have found that the photopolymerizable compositions disclosed in the above-mentioned U.S. Patent 4,042,386 work best with lower reflectivity substrates (e.g., a high degree of antihalation) in order to provide developed photopolymerizable elements having the desired dot depth characteristics in highlight, middle tone and shadow image areas.

We have now devised improved photopolymerizable compositions which can be used without any pre-exposure or $CO_2$ conditioning, and can therefore be directly imagewise exposed and then developed with water without costly or time-consuming pre-exposure conditioning.

According to the present invention, there is provided a water-developable photopolymerisable composition which comprises:

(i) a photopolymerisation initiator;

(ii) at least one ethylenically unsaturated monomer which is photopolymerisable in the presence of (i), said at least one monomer comprising at least one water-soluble monoethylenically unsaturated monomer and, optionally, at least one polyethylenically unsaturated monomer; and

(iii) at least one partially saponified polyvinyl acetate having an average polymerisation degree of

300 to 2000 and an average saponification degree of 65 to 99 mole%.

The improvement according to the invention is that the composition contains a phosphine of the formula

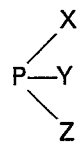

in which X is an aryl group optionally substituted by alkoxy, halogen or alkyl and Y and Z are each independently alkoxy, hydrogen, halogen, any group that X may be an alkyl group optionally substituted by alkoxy or halogen.

It is preferred that not more than one of Y and Z is hydrogen; it is further preferred that X is optionally substituted phenyl, as is at least one of Y and Z.

As mentioned above, the phosphine must contain at least one optionally substituted aryl group (X) since phosphines without such aryl groups (such as tri-n-butyl phosphine) have been found to be unsatisfactory. Preferred phosphines include triphenyl phosphine, o-tolyl diphenyl phosphine, di-(o-tolyl) phenyl phosphine, tri-(o-tolyl) phosphine, o-methoxyphenyl diphenyl phosphine, o-ethylphenyl diphenyl phosphine, and o-chlorophenyl diphenyl phosphine; triphenyl phosphine is most preferred because of its improved sensitivity, cost and air stability.

Photopolymerisable compositions containing a photopolymerisation initiator, one or more ethylenically unsaturated monomers and a phosphine falling within the above definition have been previously proposed, for example, in U.S. Patents 3832188 and 3933682 (although U.S. Patent 3832188 is concerned with a polymerisable system very different to that employed in the present invention).

U.S. Patent 3933682 suggests that organic compounds of nitrogen, phosphorus, arsenic and bismuth are all generally equivalent as activators for photopolymerisation initiators and there is no hint or suggestion that phosphines having at least one aryl or substituted aryl groups are much better in water-developable compositions. In fact, neither U.S. Patent 3832188 nor U.S. Patent 3933682 is concerned with water-developable compositions and neither has any disclosure of the inclusion of partially hydrolysed polyvinyl acetate as specified above in a photopolymerisable composition containing a photopolymerisation initiator and a phosphine.

The present invention also comprises a photosensitive element comprising a substrate having thereon a layer of photopolymerisable composition according to the invention; the present invention further comprises a process of producing a printing plate, which comprises exposing the layer of photopolymerisable composition of an element as just defined to light of a wavelength less than 400 nm, removing the photopolymerisable composition from the unexposed areas by washing with water, and drying the element.

The photosensitive elements according to the invention can incorporate a wide range of monomers and polymers, require shortened exposure times and less antihalation conditioning of the substrate, can be exposed with less intense light, and yet still provide consistently improved printing characteristics; e.g., improved dot depth in highlight, middle tone and shadow image areas, and improved minimum line width and shapes in reverse areas. Furthermore, the photopolymerizable compositions of the present invention can be applied to ultra-shallow relief plates, such as 0.1 to 0.2 mm in relief thickness, because such compositions are not adversely affected by oxygen exposure.

The initiator (i) is preferably an acetophenone, benzophenone or benzoin. Benzoin derivatives are generally soluble in the monomer component (ii) and in water, do not decompose thermally below about 100°C, and do not harden or become insoluble with heating during the preparation of the photopolymerizable composition. Specific examples of benzoin derivatives for use in compositions according to the invention are the methyl, ethyl, isopropyl, isobutyl, octyl, vinyl, aryl and allyl ethers of benzoin. The preferred benzophenone is benzophenone itself; other suitable benzophenones include 2-methoxybenzophenone, 2-methylbenzophenone and 2,2-dimethoxybenzophenone. The most preferred initiators, are acetophenone derivatives, such as 2,2-dimethoxy-2-phenyl acetophenone, 2,2-diethoxy-2-phenyl acetophenone, 2,2-diisopropoxy-2-phenyl acetophenone, and 2,2-di-n-butoxy-2-phenyl acetophenone, because of their unexpectedly high solubility in the monomer component (ii) and their excellent photoinitiation properties.

Although ordinarily photopolymerization requires a photoinitiator such as an anthraquinone compound in addition to the polymerization initiators discussed above, a high photosensitivity can be attained in the present invention by using initiators such as acetophenones or benzoins alone.

The monomer component (ii) preferably comprises an acrylic or methacrylic ester, such as a monoethylenically unsaturated acrylic or methacrylic ester of a lower alkanol having one or more hydroxy groups, optionally together with a polyethylenically unsaturated monomer. The latter is preferably an acrylic or methacrylic ester of polyethylene glycol [$HO(CH_2CH_2O)_nH$], wherein n is desirably from 1 to 23, or at least one of pentaerythritol dimethacrylate, trimethylolpropane trimethacrylate, tetramethylolmethane tetramethacrylate and trimethylolethane trimethacrylate.

Examples of suitable monoethylenically unsaturated monomers include beta-hydroxyethyl acrylate, beta-hydroxyethyl methacrylate and beta-hydroxypropyl acrylate.

As mentioned above, the monomer component (ii) may be a mixture of both mono- and polyethylenically unsaturated monomers, in which case the monoethylenically unsaturated monomer solubilizes (i), and the polyethylenically unsaturated monomer enhances the adhesive characteristics of the resultant photopolymerizable composition; this enables a balance of water-washability and adhesion to be obtained.

The polymer component (iii) is a partially saponified polyvinyl acetate having an average degree of polymerization of 300 to 2,000 and a saponification degree of 65 to 99 mole percent. If a suitable partially saponified polyvinyl acetate cannot be obtained by saponifying homopolymer polyvinyl acetate having a low saponification degree, a copolymer obtained, for example, by copolymerizing vinyl acetate with maleic anhydride can be partially saponified to give the desired polymer. Saponification is used herein in its usual sense to mean the conversion of ester groups into alcohol groups and the saponification degree therefore represents the extent to which ester groups have been converted to hydroxy groups.

The hardness of the obtained printing plate as well as the speed of washing out in development depends directly on the degree of saponification. There are some cases, for example, wherein a certain degree of saponification is required for compatibility with certain monomer components. Thus, the required degree of saponification may be obtained by mixing two or more partially saponified polyvinyl acetate polymers having different degrees of saponification provided that the arithmetic average of the different degrees of saponification is in the range specified above. Mixtures of two or more polymers can be used, therefore, each having a different saponification degree, to obtain the desired average saponification degree for any given monomer component. This feature of the present invention adds significant flexibility to the formulation process and contributes significantly to the balance of properties that are desired for the photopolymerizable composition.

The amounts of the various components of the photopolymerizable composition of the present invention are preferably as follows: a) 0.1 to 3.0 parts by weight of (ii); b) 0.1 to 3.0 parts by weight of (iii); c) 0.001 to 0.3 parts by weight of (i); and d) 0.001 to 0.3 parts by weight of the phosphine (although proportions outside these ranges can be used if desired). When the concentration of the phosphine is outside the range specified, however, the photopolymerizable composition is so light sensitive that it is very difficult to handle the photosensitive element prior to imagewise exposure. Also, too much phosphine causes the photopolymerizable composition to become heat sensitive which further interferes with the practical use of the photosensitive elements and reduces their useful shelf life.

When, on the other hand, the concentration of the phosphine used is less than that specified in the broad concentration range above, the sensitivity of the photosensitive element may be too low to be practically used without the undesired pre-exposure conditioning.

It is desirable in some instances to add to the photopolymerizable composition of this invention 0.01 to 0.3 percent, based upon the amount of (ii), of a thermal polymerization inhibitor; examples of suitable such inhibitors include 2,6-di-t-butyl-p-cresol, hydroquinone, and p-methoxyphenol. The preferred inhibitor is 2,6-di-t-butyl-p-cresol because of its compatibility with the other components.

Small amounts of dyestuffs may also be added to the photopolymerizable composition (to provide antihalation properties). Generally, the dye is added in an amount just below that at which the composition becomes hazy (for example, 20 to 150 ppm based on the amount of the photopolymerizable composition). Examples of suitable dyestuffs include one or more of rose bengal, eosine, methylene blue and malachite green.

The photosensitive element according to the invention comprises a substrate having the photopolymerisable composition according to the invention thereon, as mentioned above. The substrate may be of plastics or metal and is preferably chemically or physically roughened prior to application of the photopolymerisable composition in order to ensure strong adhesion. This roughening or grating of the substrate surface eliminates the need for a separate adhesive layer although such may be used, where desired, in certain instances.

The preferred substrate is a metallic plate, more preferably an aluminium or tin plate. As described in U.S. Patent 3,877,939, the use of a dispersed antihalation material can be eliminated by treating the substrate with an aqueous solution of a chromic compound. Thus, for example, an aluminium plate may be abraded and then chemically treated to impart the desired antihalation properties. The preferred chemical treatment for obtaining these antihalation properties is a chemical solution of a chromic compound which includes, for example, chromic acid, water soluble salts of chromic acid and ferricyanic or ferrocyanic acid and water soluble salts thereof.

Generally, a treating composition for such a purpose contains either chromic acid or sodium bichromate, and mixtures of potassium ferricyanide, barium fluosilicate, sodium ferrocyanide, sodium fluoborate, potassium fluozirconate and similar compositions. The presently preferred treating composition is 2 percent aqueous solution of "Alodine 1200" manufactured by Amchem Products, Inc., Ambler, Pennsylvania. The treating composition is typically first placed in a bath and then the aluminium or tin

plate is immersed in the bath for approximately 40 seconds. After the plate has been treated in this fashion, it generally changes its colour from metallic to orange, whereby the plate provides antihalation activity.

As discussed above, the degree of antihalation required in the photopolymer plates made from photosensitive elements according to the present invention is reduced, since the presence of the phosphine in the composition minimizes the need for lower reflectivity substrates, and thus reduces the manufacturing cost of the photopolymerizable compositions.

Moreover, the exposure of the photosensitive element involves the step of subjecting the element to a single imagewise exposure of actinic light. Although prior photosensitive elements required the use of high intensity point sources such as carbon arc lamps and/or high pressure mercury lamps, exposure of the photopolymerizable composition of the present invention may be carried out under diffusion light sources such as black light tubes, otherwise known as chemical lamps. These chemical lamps are far less expensive that the prior high intensity point sources, use considerably less energy, and generate less heat. Such chemical lamps give off actinic light with wavelengths in the desired range of 300—400 nm, and provide the further advantage of generating better shoulders in the final relief image which results in improved resolution and highlight reproduction.

By eliminating the previously required pre-exposure conditioning, the photopolymerizable compositions of the present invention enable the plate processing time to be shortened and enable the photosensitive elements to be readily used in automatic developing equipment. It is not necessary to engage in the time consuming task of first bump exposing a plate, and then placing a negative on the plate for imagewise exposure. Instead, a negative can be immediately placed on the plate (without bump exposure) and then exposed for a shorter period of time with less intense light, without sacrificing printing plate quality in terms of dot depth or minimum line size.

The photosensitive element according to the invention can have a wide range of thickness for the photopolymerizable composition coating. For example, the element may be a relief plate having photopolymer thicknesses greater than 0.5 mm and shallow relief plates having photopolymer layers between 0.1 and 0.5 mm thick. The preferred thickness is in the range 0.1 to 0.89 mm.

For shallow relief plates, an interlayer is preferably interposed between the substrate and photopolymer layer; a preferred interlayer contains dispersed within it particles which are present in a size and concentration sufficient to create a plurality of protuberances in background areas of the photosensitive element after its exposure and development, to create a relief image.

The interlayer preferably contains, as binder, a polyester, a polyurethane, an ethylene-butadiene copolymer, a polyvinyl acetate derivative, a polyamide, an epoxy resin, a styrene-butadiene copolymer (preferred), mixtures of such copolymers and partially hydrolyzed polyvinyl acetate. The polyester may be an unsaturated polyester made, for example, from diethylene glycol, maleic anhydride and phthalic anhydride, the polyester may be mixed with partially hydrolyzed polyvinyl acetate, or with a mixture of glyoxal and partially hydrolyzed polyvinyl acetate.

The dispersed particles may be, for example, of glass, polytetrafluroethylene (for example, available under the Trade Mark Teflon), and alumina beads. The particle size and concentration will, of course, be chosen depending on the printing parameters such as the thickness of the relief image, printing pressures and number of repetitions.

In order that the present invention may be more fully understood, the following Examples (in which all percentages and parts are by weight unless otherwise indicated) are given by way of illustration only.

## Example 1

Substrates for the photosensitive elements used below are prepared as follows:

Method A: An aluminium plate is immersed in a surface treating agent comprising sodium bichromate (1.0 part), concentrated sulphuric acid (10 parts) and water (30 parts) at 70 to 80°C for about 20 minutes. Then, the plate is washed with water and dried.

Method B: A tin plate is immersed in a detergent comprising Ridoline (1.0 part; manufactured by Amchem Products, Inc.) and water (30 parts) at 65°C for about 20 minutes. Then, the plate is washed with water and dried.

Method D: The solution (60 parts) which consists of 14 parts of partially saponified polyvinyl acetate (average polymerization degree, 500; saponification degree, 7.0 mole%) and 86 parts of water, and the wellground pigment paste (10 parts) which consists of 14 parts of the above-mentioned polyvinyl acetate, 56 parts of water and 30 parts of red iron oxide pigment (RO—5097) manufactured by Pfizer) are mixed together. A latex of carboxylated styrene/butadiene copolymer (20 parts) XD—655 manufactured by Dow Chemical Co.) is added to the resulting solution gradually under stirring. The solution is cast on the plate which is described in Method B and dried for 2 minutes at 190°C to form the layer 15 $\mu$m in thickness.

Method D: The solution (60 parts) which consists of 14 parts of partialkly saponified polyvinyl acetate (average polymerization degree, 500; saponification degree, 78.0 mole%) and 86 parts of water, and the well-ground pigment paste (15 parts) which consists of 14 parts of above-mentioned polyvinyl acetate, 56 parts of water and 30 parts of red iron oxide pigment (RO—5097) manufactured

by Pfizer) are mixed together. The latex of carboxylated styrene/butadiene copolymer (20 parts) (XD—655 manufactured by Dow Chemical Co.) is poured into the resulting solution gradually under stirring, and 5 parts of Teflon powder (TL—115 by LNP Co.) is added into the solution. The solution is cast on a plate as described in Method B and dried for 2 minutes at 190°C to form the layer 20 μm in thickness.

Example 2

A mixture of partially saponified polyvinyl acetate (average polymerization degree, 500; saponification degree, 82.0 mole%) (35 parts), water (30 parts) and Rose bengal (30 ppm of all components by weight) is kneaded in a kneader at 80 to 90°C for 30 minutes. Then, this mixture is cooled to 60°C and a mixture of diethylene glycol dimethacrylate (5 parts), beta-hydroxyethyl methacrylate (28 parts), hydroquinone (0.1% of total monomer by weight), benzoin iso-propyl ether (0.5 part) and triphenyl phosphine (1.5 parts) is added and stirred for 30 minutes. The resulting photopolymerizable composition is cast on a plate as described in Example 1, Method C. A polyester sheet is placed thereon and the resulting piled product is passed between two rolls. After cooling, the polyester sheet is peeled off and the plate is dried in a dryer at 75°C for 40 minutes to form a photosensitive layer 0.5 mm thick.

Example 3

A mixture of partially saponified polyvinyl acetate (average polymerization degree, 500; saponification degree 77.0 mole%) (5 parts), partially saponified polyvinyl acetate (average polymerization degree, 500; saponification degree 82.0 mole%) (30 parts), water (30 parts) and Eosin (30 ppm of all components by weight) is kneaded in a kneader at 80 to 90°C for 30 minutes. Then, this mixture is cooled to 60°C and a mixture of ethylene glycol dimethacrylate (8 parts), beta-hydroxypropyl methacrylate (25 parts), hydro-quinone (0.1% of total monomer by weight), 2,2-dimethoxy-2-phenyl acetophenone (1.0 part) and triphenyl phosphine (1.0 part) is added and stirred for 30 minutes. The resulting photopolymerizable composition is cast on a plate as described in Example 1, Method C. The photosensitive plate is obtained by the same method as described in Example 2, and the photosensitive layer is 0.5 mm thick.

Example 4

A mixture of partially saponified polyvinyl acetate (average polymerization degree, 500; saponification degree 82.0 mole%) (35 parts), water (30 parts) and Rose bengal (30 ppm of all components by weight) is kneaded in a kneader at 80° to 90°C for 30 minutes. Then, this mixture is cooled to 60°C fand a mixture of ethylene glycol dimethacrylate (5 parts), beta-hydroxypropyl methacrylate (28 parts), hydroquinone (0.1% of total monomer by weight), benzoin iso-propyl ether (1.0 parts) and O-tolyl diphenyl phosphine (1.0 part) is added and stirred for 30 minutes. The resulting photopolymerizable composition is cast on the plate which is described in Example 1, Method A. The photosensitive plate is obtained by the same method as described in Example 2, and the photosensitive layer is 0.5 mm thick.

Example 5

The photosensitive resin which is obtained by the method in Example 3, is cast on a plate as described in Example 1, Method D, and the photosensitive layer is 0.125 mm thick after drying.

Example 6 (comparative example)

A mixture of partially saponified polyvinyl acetate (average polymerization degree, 500; saponification degree, 82.0 mole%) (35 parts), water (30 parts) and Rose bengal (50 ppm of all components by weight) is kneaded in a kneader at 80 to 90°C for 30 minutes. Then, this mixture is cooled to 60°C and a mixture of ethylene glycol dimethacrylate (2 parts), beta-hydroxyethyl methacrylate (32 parts), hydroquinone (0.1% of total monomer by weight) and benzoin isopropyl ether (1.0 part) is added and stirred for 30 minutes. The resulting photopolymerizable composition is cast on a plate as described in Example 1, Method A. The photosensitive plate is obtained by the same method as described in Example 2, and the photosensitive layer is 0.5 mm thick.

Example 7 (comparative example)

The photosensitive resin which is obtained by the method in Example 6, is cast on a plate which is as described in Example 1, Method C, and the photosensitive layer is 0.5 mm thick after drying.

Example 8

The photopolymer plate made according to Example 3 is placed in a vacuum frame and the photopolymerizable surface is brought into contact with a line negative or a half tone negative. It is exposed to a 3,000 watt high pressure mercury arc for 50 seconds from a distance of 50.8 cm. After exposure, the negative is stripped from the plate and the unexposed polymer is removed by spray washing with water (temperature, 49°C) under the pressure of 0.28 N/mm² for 3 minutes. The printing

plate is dried at 110°C for 3 minutes. The printing plates thus prepared show excellent image quality and long press life when used for direct printing and also are utilizable as original plates for a paper mache.

Table I demonstrates the comparison in quality between the photosensitive plates with (Examples 3 and 4) and without (Examples 6 and 7) phosphine derivatives.

TABLE I

| | Example 3 | Example 4 | Example 6 | Example 7 |
|---|---|---|---|---|
| Exposure Time (sec) | 50 | 45 | 180 | 195 |
| Dot Depth (μm) | | | | |
| 10% Hi-light | 270 | 260 | 160 | 175 |
| 45% Middle tone | 125 | 120 | 50 | 60 |
| 90% Shadow | 55 | 50 | Plug Dot | Plug Dot |
| Width of Minimum | | | | |
| Remaining Line (μm) | 40 | 40 | 140 | 140 |
| Gray Step | 17 | 17 | 13 | 13 |

As shown in Table I above, photopolymer plates made with the photopolymerizable compositions of the present invention have improved dot depth characteristics in hi-light, middle tone and shadow areas. Dot depths that are less than 200 μm in hi-light areas, 80 μm in middle tone areas and 35 μm in shadow areas, (as is the case in Examples 6 and 7) provide dark, unacceptable half tone areas. Moreover, line widths above 50 to 60 μm are generally regarded as unacceptable in newspaper printing applications.

The significance of component selection in the present invention can be demonstrated through a series of tests in which (1) derivatives employing Group V elements other than phosphorus are substituted for the phosphines used according to the present invention, (2) phosphines with no phenyl groups (not according to the invention) are used instead of phosphines having 1, 2 or 3 phenyl groups, and (3) halogenated compounds such as pentachlorobenzene are used as an additional component in the present invention. Table II sets forth on the following page shows the results of such tests:

TABLE II

| | | | 1 | 2 | 3 |
|---|---|---|---|---|---|
| Formulation | PVA (Saponification degree 77.0 mol %) | | 5 | 5 | 5 |
| | PVA (Saponification degree 82.0 Mol %) | | 30 | 30 | 30 |
| | Water | | 30 | 30 | 30 |
| | Eosin | | 30 ppm | 30 ppm | 30 ppm |
| | Ethyleneglycol dimethacrylate | | 8 | 8 | 8 |
| | Beta-Hydroxypropyl methacrylate | | 25 | 25 | 25 |
| | Hydroquinone | | 0.1% of monomer | 0.1% of monomer | 0.1% of monomer |
| | 2,2-Dimethoxy-2-phenyl acetophenone | | 1 | 1 | 1 |
| | * Activator | | TPP 1 | BDP 1 | CPP 1 |
| | Pentachlorobenzene | | 0 | 0 | 0 |
| Exposure Time (sec.) | | | 50 | 58 | 65 |
| Plate Quality | Dot Depth (μm) | 10% Hi-light | 270 | 275 | 265 |
| | | 45% Middle Tone | 125 | 120 | 120 |
| | | 90% Shadow | 55 | 55 | 55 |
| | Width of Minimum Remaining Line (μm) | | 40 | 50 | 50 |
| | Gray Step | | 17 | 16 | 16 |
| | Overall Quality | | Acceptable | Acceptable | Acceptable |

* TPP: Triphenylphosphine
BDP: n-Butyldiphenylphosphine
CPP: Dichlorophenylphosphine
TBP: Tri-n-butylphosphine
TPA: Triphenylarsine
TPS: Triphenylantimony
BPP: Dibutylphenylbismuthine
TPN: Triphenylamine
TEA: Triethanolamine

TABLE II (Continued)

| | | | 4 | 5 | 6 |
|---|---|---|---|---|---|
| Formulation | PVA (Saponification degree 77.0 mol %) | | 5 | 5 | 5 |
| | PVA (Saponification degree 82.0 mol %) | | 30 | 30 | 30 |
| | Water | | 30 | 30 | 30 |
| | Eosin | | 30 ppm | 30 ppm | 30 ppm |
| | Ethyleneglycol dimethacrylate | | 8 | 8 | 8 |
| | Beta-Hydroxypropyl methacrylate | | 25 | 25 | 25 |
| | Hydroquinone | | 0.1% of monomer | 0.1% of monomer | 0.1% of monomer |
| | 2,2-Dimethoxy-2-phenyl acetophenone | | 1 | 1 | 1 |
| | * Activator | | TBP 1 | TPP 1 | TPA 1 |
| | Pentachlorobenzene | | 0 | 0.5 | 0 |
| Exposure Time (sec.) | | | 120 | 50 | 150 |
| Plate Quality | Dot Depth (μm) | 10% Hi-light | 150 | 270 | 140 |
| | | 45% Middle Tone | 55 | 120 | 50 |
| | | 90% Shadow | Plug Dot | 55 | Plug Dot |
| | Width of Minimum Remaining Line (μm) | | 140 | 40 | 50 |
| | Gray Step | | 13 | 17 | 15 |
| | Overall Quality | | Not Acceptable | Acceptable | Not Acceptable |

* TPP: Triphenylphosphine
BDP: n-Butyldiphenylphosphine
CPP: Dichlorophenylphosphine
TBP: Tri-n-butylphosphine
TPA: Triphenylarsine
TPS: Triphenylantimony
BPP: Dibutylphenylbismuthine
TPN: Triphenylamine
TEA: Triethanolamine

TABLE II (Continued)

| | | | 7 | 8 | 9 |
|---|---|---|---|---|---|
| Formulation | PVA (Saponification degree 77.0 mol %) | | 5 | 5 | 5 |
| | PVA (Saponification degree 82.0 mol %) | | 30 | 30 | 30 |
| | Water | | 30 | 30 | 30 |
| | Eosin | | 30 ppm | 30 ppm | 30 ppm |
| | Ethyleneglycol dimethacrylate | | 8 | 8 | 8 |
| | Beta-Hydroxypropyl methacrylate | | 25 | 25 | 25 |
| | Hydroquinone | | 0.1% of monomer | 0.1% of monomer | 0.1% of monomer |
| | 2,2-Dimethoxy-2-phenyl acetophenone | | 1 | 1 | 1 |
| | * Activator | | TPS 1 | BPP 1 | TPN 1 |
| | Pentachlorobenzene | | 0 | 0 | 0 |
| Exposure Time (sec.) | | | 135 | 155 | 165 |
| Plate Quality | Dot Depth (μm) | 10% Hi-light | 155 | 140 | 130 |
| | | 45% Middle Tone | 55 | 50 | 45 |
| | | 90% Shadow | Plug Dot | Plug Dot | Plug Dot |
| | Width of Minimum Remaining Line (μm) | | 50 | 80 | 130 |
| | Gray Step | | 15 | 14 | 13 |
| | Overall Quality | | Not Acceptable | Not Acceptable | Not Acceptable |

* TPP: Triphenylphosphine
BDP: n-Butyldiphenylphosphine
CPP: Dichlorophenylphosphine
TBP: Tri-n-butylphosphine
TPA: Triphenylarsine
TPS: Triphenylantimony
BPP: Dibutylphenylbismuthine
TPN: Triphenylamine
TEA: Triethanolamine

TABLE II (Continued)

| | | | 10 | 11 | 12 |
|---|---|---|---|---|---|
| Formulation | PVA (Saponification) degree 77.0 mol %) | | 5 | 5 | 5 |
| | PVA (Saponification degree 82.0 mol %) | | 30 | 30 | 30 |
| | Water | | 30 | 30 | 30 |
| | Eosin | | 30 ppm | 30 ppm | 30 ppm |
| | Ethyleneglycol dimethacrylate | | 8 | 8 | 8 |
| | Beta-Hydroxypropyl methacrylate | | 25 | 25 | 25 |
| | Hydroquinone | | 0.1% of monomer | 0.1% of monomer | 0.1% of monomer |
| | 2,2-Dimethoxy-2-phenyl acetophenone | | 1 | 1 | 1 |
| | * Activator | | TEA 1 | 0 | TBP 1 |
| | Pentachlorobenzene | | 0 | 0 | 0.5 |
| Exposure Time (sec.) | | | 180 | 160 | 120 |
| Plate Quality | Dot Depth (μm) | 10% Hi-light | 120 | 160 | 145 |
| | | 45% Middle Tone | 45 | 50 | 55 |
| | | 90% Shadow | Plug Dot | Plug Dot | Plug Dot |
| | Width of Minimum Remaining Line (μm) | | 150 | 140 | 140 |
| | Gray Step | | 11 | 13 | 13 |
| | Overall Quality | | Not Acceptable | Not Acceptable | Not Acceptable |

* TPP: Triphenylphosphine
BDP: n-Butyldiphenylphosphine
CPP: Dichlorophenylphosphine
TBP: Tri-n-butylphosphine
TPA: Triphenylarsine
TPS: Triphenylantimony
BPP: Dibutylphenylbismuthine
TPN: Triphenylamine
TEA: Triethanolamine

Examples 1, 2 and 3 demonstrate that the use of phosphine derivatives having 3 (triphenyl phosphine), 2 (n-butyldiphenyl phosphine) and 1 (dichlorophenyl phosphine) phenyl groups in the phosphine activator component all produce printing plates with satisfactory properties. Surprisingly, however, the degree of acceptance decreases as the number of phenyl groups decreases from 3 to 1, e.g., exposure time increases, dot depth decreases, and gray step values decrease, but all within acceptable limits.

Example 4 demonstrates that the use of a phosphine with no phenyl groups (tri-n-butyl phosphine), with all other parameters remaining the same, does not result in a printing plate having satisfactory conditions for newspaper printing applications.

Likewise when derivatives of Group V elements such as nitrogen, arsenic, antimony and bismuth are used in place of a phosphine, the resultant printing plate has unsatisfactory properties (Examples 6—10). Surprisingly, this is the case even when three phenyl groups are used (triphenylarsine, triphenylantimony and triphenylamine), or when two phenyl groups are used (dibutylphenylbismuthine).

Finally, the presence of a halogenated compound such as pentachlorobenzene neither improves the properties of the resultant plate (compare Examples 1 and 5) nor renders the resultant plate satisfactory in the absence of a phosphine derivative with at least one phenyl group (compare Examples 4 and 12).

## Claims

1. A water-developable photopolymerisable composition comprising:

(i) a photopolymerisation initiator;

(ii) at least one ethylenically unsaturated monomer which is photopolymerisable in the presence of said initiator, said at least one monomer comprising at least one water-soluble monoethylenically unsaturated monomer and, optionally, at least one polyethylenically unsaturated monomer; and

(iii) at least one partially saponified polyvinyl acetate having an average polymerisation degree of 300 to 2000 and an average saponification degree of 65 to 99 mole%, characterised in that the composition contains a phosphine of the formula

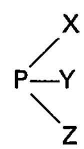

in which X is an aryl group optionally substituted by alkoxy, halogen or alkyl, and Y and Z are each independently alkoxy, hydrogen, halogen, any group that X may be, or an alkyl group optionally substituted by halogen or an alkoxy group.

2. A composition according to claim 1, characterised in that the phosphine is triphenyl phosphine, *o*-tolyl diphenyl phosphine, di-(*o*-tolyl)phenyl phosphine, tri-(*o*-tolyl)phosphine, *o*-methoxyphenyl diphenyl phosphine, *o*-ethylphenyl diphenyl phosphine or *o*-chlorophenyl diphenyl phosphine.

3. A composition according to claim 1 or 2, characterised in that the photopolymerisation initiator is a benzoin, acetophenone or benzophenone.

4. A composition according to any of claims 1 to 3, characterised in that the water-soluble monomer is an acrylic or methacrylic ester.

5. A composition according to claim 4, characterised in that the water-soluble monomer is beta-hydroxyethyl acrylate or methacrylate.

6. A composition according to any of claims 1 to 5, characterised in that the polyethylenically unsaturated monomer is an ester of acrylic or methacrylic acid and a polyethylene glycol having 1 to 23 ethylene oxide units, or at least one of pentaerythritol dimethacrylate, tetramethylolmethane tetramethacrylate and trimethylolethane trimethacrylate.

7. A composition according to any of claims 1 to 6, characterised in that it comprises 0.1 to 3.0 parts by weight of said at least one monomer, 0.1 to 3.0 parts by weight of said partially saponified polyvinyl acetate, 0.001 to 0.3 parts by weight of said initiator and 0.001 to 0.3 parts by weight of said phosphine.

8. A composition according to any of claims 1 to 7, characterised in that it contains a thermal polymerisation inhibitor in an amount of 0.01 to 0.3%, based on the weight of the monomer.

9. A composition according to any of claims 1 to 8, characterised in that it contains a minor amount of dyestuff.

10. A photosensitive element comprising a substrate having thereon a layer of photopolymerisable composition, characterised in that the composition is as claimed in any of claims 1 to 9.

11. An element according to claim 10, characterised in that the substrate is a chemically or physically roughened metal or plastics plate.

12. An element according to claim 10 or 11, characterised in that the layer of photopolymerisable composition has a thickness of 0.1 to 0.89 mm.

13. An element according to any of claims 10 to 12, characterised in that an interlayer comprising a binder having particulate material dispersed therein is present between the layer of photopolymerisable composition and the substrate, the particulate material having a particle size and concentration such as to create a plurality of protuberances in background areas of the element after exposure and development thereof to produce a relief image.

14. An element according to claim 13, characterised in that the particulate material is glass beads, alumina, or polytetrafluoroethylene powder.

15. An element according to claim 13 or 14, characterised in that the binder in the interlayer is a styrene-butadiene copolymer or a polyester.

16. A process of producing a printing plate, which comprises exposing the layer of photopolymerisable composition of an element according to any of claims 10 to 15 to light of a wavelength less than 400 nm, removing the photopolymerisable composition from the unexposed areas by washing with water, and drying the element.

## Revendications

1. Une composition photopolymérisable et développable par l'eau comprenant:

(i) un inducteur de photopolymérisation;

(ii) au moins un monomère à insaturation éthylénique photopolymérisable en présence dudit inducteur, ce monomère comprenant au moins un monomère à insaturation monoéthylénique soluble dans l'eau et, facultativement, au moins un monomère à insaturation polyéthylénique; et

(iii) au moins un acétate de polyvinyle partiellement saponifié présentant un degré de polymérisation moyen de 300 à 2000 et un degré de saponification moyen de 65 à 99 moles%, caractérisée en ce que la composition contient une phosphine de fomule

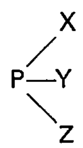

dans laquelle X est un groupe aryle éventuellement substitué par des groupes alcoxy, des halogènes ou des groupes alkyle et Y et Z représentent chacun, indépendamment, un groupe alcoxy, un atome d'hydrogène, un atome d'halogène, un groupe quelconque tel que représenté par X ou un groupe alkyle éventuellement substitué par un halogène ou un groupe alcoxy.

2. Une composition selon la revendication 1, caractérisée en ce que la phosphine est la triphénylphosphine, l'o-tolyldiphényl-phosphine, la di-(o-tolyl)-phényl-phosphine, la tri-(o-tolyl)-phosphine, l'o-méthoxyphényl-diphényl-phosphine, l'o-éthyl-phényldiphényl-phosphine ou l'o-chlorophenyl-diphényl-phosphine.

3. Une composition selon la revendication 1 ou 2, caractérisée en ce que l'inducteur de photopolymérisation est une benzoïne, une acétophénone ou une benzophénone.

4. Une composition selon l'une quelconque des revendications 1 à 3, caractérisée en ce que le monomère hydrosoluble est un ester acrylique ou méthacrylique.

5. Une composition selon la revendication 4, caractérisée en ce que le monomère hydrosoluble est l'acrylate ou le méthacrylate de bêta-hydroxyéthyle.

6. Une composition selon l'une quelconque des revendications 1 à 5, caractérisée en ce que le monomère à insaturation polyéthylénique est un ester de l'acide acrylique ou méthacrylique et d'un polyéthylèneglycol contenant de l à 23 motifs d'oxyde d'éthylène, ou au moins un composé du groupe du diméthyacrylate de pentaérythritol, du tétramethacrylate de tétraméthylalméthane et du triméthacrylate du triméthyloléthane.

7. Une composition selon l'une quelconque des revendications 1 à 6, caractérisée en ce qu'elle comprend 0,1 à 3,0 parties en poids dudit monomère, 0,1 à 3,0 parties en poids dudit acétate de polyvinyle partiellement saponifié, 0,001 à 0,3 partie en poids dudit inducteur et 0,001 à 0,3 partie en poids de ladite phosphine.

8. Une composition selon l'une quelconque des revendications 1 à 7, caractérisée en ce qu'elle contient un inhibiteur de polymérisation à la chaleur en proportions de 0,01 à 0,3% du poids du monomère.

9. Une composition selon l'une quelconque des revendications 1 à 8, caractérisée en ce qu'elle contient une proportion mineure de colorant.

10. Un élément photosensible comprenant un substrat portant une couche d'une composition photopolymérisable, caractérisé en ce que la composition est telle que revendiquée dans l'une quelconque des revendications 1 à 9.

11. Un élément selon la revendication 10, caractérisé en ce que le substrat est une plaque de métal ou de matière plastique dépolie chimiquement ou physiquement.

12. Un élément selon la revendication 10 ou 11, caractérisé en ce que la couche de composition

photopolymérisable a une épaisseur de 0,1 à 0,89 mm.

13. Un élément selon l'une quelconque des revendications 10 à 12, caractérisé en ce qu'une couche intermédiaire comprenant un liant dans lequel on a dispersé une matière en particules est présente entre la couche de composition photopolymérisable et le substrat, la matière en particules ayant une dimension de particule et une concentration telles qu'elle crée des protubérances multiples dans les régions d'arrière-plan de l'élément après exposition et développement de celui-ci pour production d'une image en relief.

14. Une élément selon la revendication 13, caractérisé en ce que la matière en particules consiste en billes de verre, alumine ou poudre de polytétrafluoréthylène.

15. Un élément selon la revendication 13 ou 14, caractérisé en ce que le liant de la couche intermédiaire est un copolymère styrène-butadiène ou un polyester.

16. Un procédé de préparation d'une plaque d'impression qui comprend l'exposition de la couche de composition photopolymérisable d'un élément selon l'une quelconque des revendications 10 à 15 à la lumière à une longueur d'ondes inférieure à 400 nm, l'élimination de la composition photopolymérisable des régions non exposées par lavage à l'eau, et le séchage de l'élément.

**Patentansprüche**

1. Wasserentwickelbare, photopolymerisierbare Zusammensetzung, umfassend:

(i) einen Photopolymerisationsinitiator;

(ii) mindestens ein äthylenisch ungesättigtes Monomer, welches in Gegenwart des Initiators photopolymerisierbar ist, wobei dieses Monomer mindestens ein wasserlösliches, monoäthylenisch ungesättigtes Monomer und, wahlweise, mindestens ein polyäthylenisch ungesättigtes Monomer umfaßt;

(iii) mindestens ein teilweise verseiftes Polyvinylacetet mit einem durchschnittlichen Polymerisationsgrad von 300 bis 2000 und einem durchschnittlichen Verseifungsgrad von 65 bis 99 Mol%, dadurch gekennzeichnet, daß die Zusammensetzung ein Phosphin der Formel:

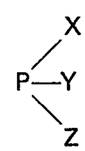

worin bedeuten:

X eine Arylgruppe, die wahlweise durch Alkoxy, Halogen oder Alkyl substituiert ist und

Y und Z jeweils unabhängig voneinander Alkoxy, Wasserstoff, Halogen, jede der für X stehenden Gruppe oder eine Alkylgruppe, die wahlweise durch ein Halogen oder durch eine Alkoxygruppe substituiert ist, enthält.

2. Zusammensetzung nach Anspruch 1, dadurch gekennzeichnet, daß das Phosphin Triphenylphosphin, o-Tolyldiphenylphosphin, Di-(o-tolyl) phenylphosphin, Tri-(o-tolyl) phosphin, o-Methoxyphenyldiphenylphosphin, o-Athylphenyldiphenylphosphin oder o-Chlorphenyldiphenylphosphin ist.

3. Zusammensetzung nach Anspruch 1 oder 2, dadurch gekennzeichnet, daß der Photopolymerisationsinitiator ein Benzoin, Acetophenon oder Benzophenon ist.

4. Zusammensetzung nach mindestens einem der Ansprüche 1 bis 3, dadurch gekennzeichnet, daß das wasserlösliche Monomer ein Acryl- oder Methacrylester ist.

5. Zusammensetzung nach Anspruch 4, dadurch gekennzeichnet, daß das wasserlösliche Monomer beta-Hydroxyäthylacrylat oder -methacrylat ist.

6. Zusammensetzung nach mindestens einem der Ansprüche 1 bis 5, dadurch gekennzeichnet, daß das polyäthylenisch ungesättigte Monomer ein Ester aus Acryl- oder Methacrylsäure und einem Polyäthylenglykol mit 1 bis 23 Äthylenoxideinheiten oder mindestens ein Vertreter aus Pentaerythritdimethacrylat, Tetermethylolmethantetramethacrylat und Trimethyloläthantrimethacrylat ist.

7. Zusammensetzung nach mindestens einem der Ansprüche 1 bis 6, dadurch gekennzeichnet, daß sie 0,1 bis 3,0 Gewichtsteile des teilweise verseiften Polyvinylacetates, 0,001 bis 0,3 Gewichtsteile des Initiators und 0,001 bis 0,3 Gewichtsteile des Phosphins enthält.

8. Zusammensetzung nach mindestens einem der Ansprüche 1 bis 7, dadurch gekennzeichnet, daß sie einen thermischen Polymerisationsinhibitor in einer Menge von 0,01 bis 0,3%, bezogen auf das Gewicht des Monomeren, enthält.

9. Zusammensetzung nach mindestens einem der Ansprüche 1 bis 8, dadurch gekennzeichnet, daß sie eine geringe Menge eines Farbstoffes enthält.

10. Lichtempfindliches Element, umfassend ein Substrat mit einer darauf befindlichen Schicht einer photopolymerisierbaren Zusammensetzung, dadurch gekennzeichnet, daß die Zusammensetzung eine solche ist, wie sie in mindestens einem der Ansprüche 1 bis 9 beansprucht wird.

11. Element nach Anspruch 10, dadurch gekennzeichnet, daß das Substrat eine chemisch oder physikalisch aufgerauhte Metall- oder Kunstoffplatte ist.

12. Element nach Anspruch 10 oder 11, dadurch gekennzeichnet, daß die Schicht der photopolymerisierbaren Zusammensetzung eine Dicke von 0,1 bis 0,89 mm besitzt.

13. Element nach mindestens einem der Ansprüche 10 bis 12, dadurch gekennzeichnet, daß zwischen der Schicht der photopolymerisierbaren Zusammensetzung und dem Substrat eine Zwischenschicht vorliegt, welche ein Bindemittel mit darin dispergiertem teilchenförmigem Material umfaßt, wobei das teilchenförmige Material solch eine Teilchengröße und Konzentration besitzt, daß eine Vielzahl von Vorsprüngen in Untergrundbereichen des Elements nach dessen Belichtung und Entwicklumg erzeugt wird, um ein Reliefbild herzustellen.

14. Element nach Anspruch 13, dadurch gekennzeichnet, daß das teilchenförmige Material aus Glaskügelchen, aluminiumoxyd oder Polytetrafluoräthylenpulver besteht.

15. Element nach Anspruch 13 oder 14, dadurch gekennzeichnet, daß das Bindemittel in der Zwischenschicht ein Styrol-Butadiencopolymer oder ein Polyester ist.

16. Verfahren zur Herstellung einer Druckplatte bei dem die Schicht aus der photopolymerisierbaren Zusammensetzung eines Elements nach mindestens einem der Ansprüche 10—15 mit Licht einer Wellenlänge von weniger als 400 nm belichtet wird, die photopolymerisierbare Zusammensetzung durch Waschen mit Wasser aus den unbelichteten Bereichen entfernt und das Element getrocknet wird.